(19) Europäisches Patentamt
European Patent Office
Office européen des brevets

(11) Publication number: 0 249 468 B1

(12) # EUROPEAN PATENT SPECIFICATION

(45) Date of publication of patent specification: 27.02.91

(51) Int. Cl.⁵: G03F 7/027, G03F 7/031, G03F 7/038

(21) Application number: 87305155.1

(22) Date of filing: 10.06.87

(54) ## Photopolymerizable composition.

(30) Priority: 10.06.86 JP 134532/86

(43) Date of publication of application:
16.12.87 Bulletin 87/51

(45) Publication of the grant of the patent:
27.02.91 Bulletin 91/09

(84) Designated Contracting States:
CH DE FR GB IT LI

(56) References cited:

| | |
|---|---|
| EP-A- 0 065 285 | EP-A- 0 125 862 |
| DE-A- 2 238 567 | FR-A- 2 251 031 |
| FR-A- 2 307 293 | US-A- 3 907 865 |
| US-A- 3 932 401 | US-A- 4 192 685 |
| US-A- 4 230 793 | US-A- 4 501 689 |

CHEMICAL ABSTRACTS, vol. 99, no. 12, 19th September 1983, page 87, no. 89755q, Columbus, Ohio, US; & JP-A-58 25 371 (TOYOBO CO., LTD) 15-02-1983

CHEMICAL ABSTRACTS, vol. 101, no. 12, 17th September 1984, page 654, no. 101237s, Columbus, Ohio, US; & JP-A-59 51 962 (TAIYO INK SEIZO K.K.) 26-03-1984

PATENT ABSTRACTS OF JAPAN, vol. 7, no. 70 (P-185)[1215], 23rd March 1983, page 106 P 185; & JP-A-58 1142 (HITACHI KASEI KOGYO K.K.) 06-01-1983

(73) Proprietor: MITSUBISHI KASEI CORPORATION
5-2, Marunouchi 2-chome Chiyoda-ku
Tokyo 100(JP)

(72) Inventor: Takahashi, Noriaki
3-1-11-101 Eda-Higashi Midori-ku
Yokohama-shi Kanagawa-ken(JP)
Inventor: Watanabe, Noriko
202 Naruse-Sutehshon-Haitsu II 1-30-2
Narusegaoka
Machida-shi Tokyo(JP)

(74) Representative: Woods, Geoffrey Corlett et al
J.A. KEMP & CO. 14 South Square Gray's Inn
London WC1R 5EU(GB)

EP 0 249 468 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a novel photopolymerizable composition having excellent properties suitable for use as a solder resist in the production of printed circuit boards or suitable for use as an electroless plating resist. It can therefore be used in the preparation of a permanent protective mask. More particularly, the present invention relates to a photopolymerizable composition suitable for use as a contact exposure type solder photoresist for printed circuit boards on which the resist is applied and, after removing the solvent, image exposure and development are conducted to form a desired pattern.

The screen printing method is popularly used for forming a solder resist in the production of printed circuit boards. This method, however, has a problem in resolution and improvement is desired.

As a resist forming technique with excellent resolution, there is known a method in which a liquid photosensitive composition is applied on the whole surface of a circuit-formed base plate and, after removing the solvent by heating, image exposure is made through a mask, followed by the development to form a resist patern. However, this method has the disadvantages of possble adhesion of the mask to the surface coat of the base plate during exposure due to the large tackiness of the coat after removal of the solvent, poor developing performance, sensitivity and solvent resistance, and unsatisfactory adherence to the solder circuit.

Screen ink solder resist compositions containing a compound such as trisacryloyloxyethyl isocyanurate of following formula (I) and an oligomer or monomer having a molecular weight of not more than 5,000 are known JP-A-25371/83 and JP-A-51962/84):

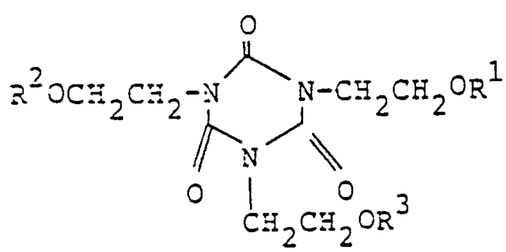

wherein $R^1$, $R^2$ and $R^3$ independently are hydrogen or a

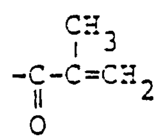

or

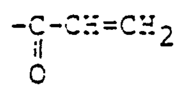

group, with the proviso that two or more of them are not simultaneously hydrogen.

The coating film formed from these compositions is tacky, but since these compositions are intended to be used as screen ink for forming images by printing and no image exposure step through a mask is involved, the surface tackiness poses no problem. However, in the case of the resist forming method wherein image exposure is made through a mask, the surface tackiness is a serious problem. Furthermore, in the case of screen ink, sensitivity at the time of image exposure and developing performance offer no problem since no image exposure or development step is involved, but they are a problem in a resist forming method.

The present invention provides a photopolymerizable composition comprising at least (A) a high-molecular weight compound having a weight-average molecular weight of not less than 10.000 and having a polymerizable double bond in a side chain, and (B) a polymerizable monomer of formula (I) as defined above. When this composition is used to form a coating film, after removing the solvent the film has little tackiness, good developability, high sensitivity, solvent resistance and excellent adhesiveness to solder.

The high-molecular weight compound (A), when combined with the polymerizable monomer of formula

(I), produces a specific synergistic effect to provide a coating film which has little tackiness, high sensitivity, good developability and excellent solvent resistance.

Examples of the high-molecular weight compound are polymers made by esterification-introducing (meth)acrylic acid into (meth)acrylic polymers containing hydroxyethyl (meth)acrylate or hydroxypropyl (meth)acrylate singly or as a copolymer; polymers made by esterification-introducing (meth)acrylic acid into the hydroxyl group of phenoxy resin; polymers made by esterification-introducing (meth)allyl group into the hydroxyl group of phenoxy resin; polymers made by addition-modifying glycidyl (meth)acrylate with the hydroxyl group of phenoxy resin; (co)polymers of diallyl (iso)phthalate and/or triallyl isocyanurate; polymers made by esterification-introducing (meth)acrylic acid, crotonic acid, cinnamic acid or the like to (co)-polymers of glycidyl (meth)acrylate; polymers made by addition-introducing glycidyl (meth)acrylate to carboxyl group-containing polymers; polymers made by reacting compound containing both of hydroxyl group and (meth)acryl group with copolymers of maleic acid; and polymers made by esterification-introducing (meth)acrylic acid to vinyl acetate polymers.

Among these polymers, those having a (meth)acryloyl group are advantageous. (Meth)acrylic polymers comprising units of formula (III) are most preferred:

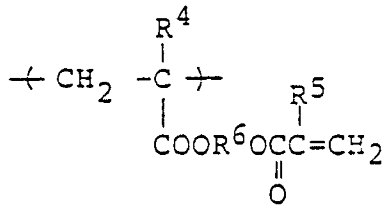

(III)

wherein $R^4$ and $R^5$ independently are hydrogen or a methyl group and $R^6$ is a

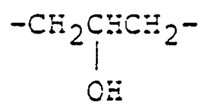 , $-CH_2CH_2-$ or 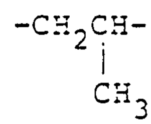

group.

The weight-average molecular weight of the high-molecular weight compounds must be not less than 10,000 to produce the desired synergistic effect with the polymerizable monomer (B) of formula (I). For preferred coatability, coating film surface tackiness and chemical resistance, the weight-average molecular weight of the high-molecular weight compound is from 30,000 to 300,000.

Examples of the polymerizable monomer of formula (I) are tris(meth)acrylolyoxyethyl isocyanurate, tris-(meth)acryloyloxypropyl isocyanurate and di(meth)acryloyloxyethylhydroxyethyl isocyanurate.

These polymerizable mononers can provide a coating film which has low tackiness, does not adhere to the mask film and has high sensitivity.

It is preferred to add a third substance (C) to the composition of the present invention. This is at least one substance selected from N-vinyl-2-pyrrolidone, a monomer comprising units of formula (II) and a urethane (meth)acrylate compound.

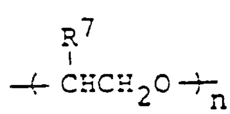

(II)

wherein n is from 5 to 25 and $R^7$ is hydrogen or a methyl group.

The addition of this third component improves the adhesiveness to a glass epoxy substrate, paper phenol substrate, copper surface or solder surface.

Examples of monomers comprising units of formula (II) are:

$CH_2=CHCOO-(CH_2CH_2O)_9-COCH=CH_2$, $CH_2=CHCOO-(CH_2CH_2O)_{14}-COCH=CH_2$,

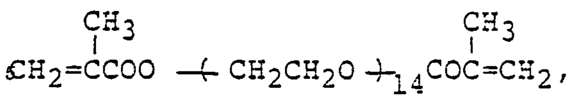 and

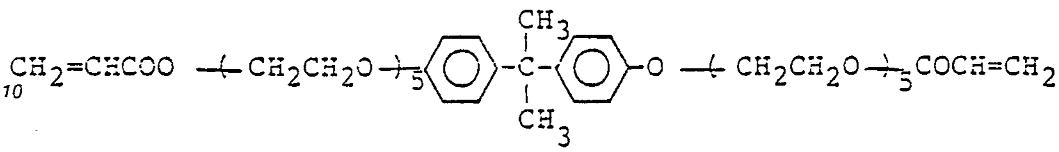 .

As the urethane (meth)acrylate compounds, the reaction products obtained by reacting diisocyanate compounds with compounds having one (meth)acrylate group and one hydroxyl group, and the reaction products obtained by reacting compounds having a (meth)acrylate group and a hydroxyl group with diisocyanate compounds obtained from the reaction of a diol compound and a diisocyanate compound may be exemplified.

As the diisocyanate compounds, lysine diisocyanate, hexamethylene diisocyanate, trimethylhexamethylene diisocyanate, diphenylmethane diisocyanate, hydrogenated diphenylmethane diisocyanate, toluene diisocyanate and hydrogenated toluene diisocyanate may be exemplified.

As the compounds having one (meth)acrylate group and one hydroxyl group, 2-hydroxyethyl (meth)-acrylate, 2-hydroxypropyl (meth)acrylate,

$$CH_2=CHCOO-(CH_2CH_2O)_p-H$$

(wherein p is n integer of not less than 2).

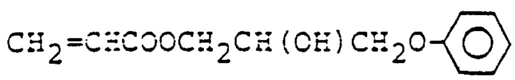, 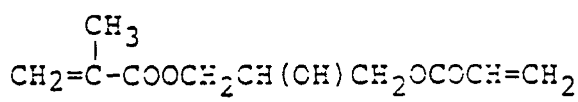,

trimethylolpropane di(meth)acrylate, pentaerithritol (meth)acrylate, dipentaerithritol penta(meth)acrylate, glycerin di(meth)acrylate and erithrite (meth)acrylate may be exemplified.

As the diol compounds, ethylene glycol, propylene glycol, diethylene glycol, butanediol, hexanediol, neopentyl glycol, hexylene glycol, dihydroxyethyl ether of bisphenol A, dihydroxyethyl ether of hydrogenated bisphenol A, cyclohexane dimethanol, dihydroxyethyl ether of bishenol A tetrabromide, and diol-terminated polyester compounds may be exemplified.

The composition of the present invention may also comprise a photopolymerization initiator (D), for example benzoin, benzoin alkyl ethers, anthraquinone derivatives, benzanthrone derivatives, 2,2-dimethoxy-2-phenylacetone, l-hydroxycyclohexyl phenyl ketone, 2-methyl-[4-(methylthio)phenyl]-2-morpholino-1-propanone, benzyl derivatives, benzophenone derivatives, 4,4'-bis-dimethyl-aminobenzophenone, xanthone derivatives, thioxanethone derivatives, biimidazoles, trichloromethyl-s-triazines and 3,4,3',4'-tetra(t-butylperoxycarbonyl)benzophenone, and combinations of these compounds with, for example, pigments, amine compounds such as dialkylaminobenzoic acid alkyl esters, allythiourea and N-phenylglycine.

The composition of the present invention may also comprise a coating solvent (E), which has a suitable melting point and is capable of dissolving the composition. Examples are methyl ethyl ketone, methyl isopropyl ketone, methyl isobutyl ketone, methyl cellosolve, ethyl cellosolve, butyl cellosolve, propylene glycol monomethyl ether, propylene glycol monoethyl ether, cyclohexanone, cellosolve acetate, carbitol and carbitol acetate.

The high-molecular weight compound (A) is generally present in an amount of from 10 to 80% by weight, preferably 10 to 50% by weight, based on the total solids content of the composition excluding any coating solvent.

The polymerizable monomer (B) of formula (I) is generally present in an amount of from 10 to 70% by weight, preferably 15 to 50% by weight, based on the total solids content of the composition.

The compound (C) is generally present in an amount of not more than 40% by weight, preferably 5 to

25% by weight, based on the total solids content of the composition.

The photopolymerization initiator (D) is generally present in an amount of from 0.05 to 10% by weight, preferably 0.3 to 6% by weight, based on the total solids content of the composition.

The composition of the present invention may further contain an ordinary (meth)acrylate compound such as an epoxy (meth)acrylate compound or an ester (meth)acrylate compound.

It is also possible to incorporate inorganic fine particles having an average diameter of not more than 10 µm. Examples are talc, calcium carbonate, silica, barium sulfate, clay and kaolin. The inorganic fine particles are generally present in an amount of from 10 to 50% by weight based on the total solids content of the composition.

Other additives such as a heat polymerization inhibitor, colorant, plasticizer, print-cut material or flame retardant, may be blended in the composition as desired.

Various coating methods such as roll coating, curtain coating or screen printing can be employed to coat the composition of the present invention on a base plate. In the case of curtain coating, it is recommended to adjust the viscosity of the composition just before coating to 100 to 1,500 cp (0.1 to 1.5 Pas), preferably 150 to 500 cp (0.15 to 0.5 Pas). After the composition has been coated on the whole surface of, for example, a printed circuit board the solvent is removed and then the area where solder is not to be deposited is masked, followed by image exposure and development. A 1,1,1-trichloroethane solution or a weakly alkaline solution is preferably used as the developer.

The composition of the present invention has good developability, especially when these developers are used.

Other applications of the composition of the present invention include a permanent protective coat for electronic parts and conductors, an insulating protective film for integrated circuits, other permanent protective coats and a precision image resist. It can also be applied to various types of resists and printing plates.

The photopolymerizable composition of the present invention has excellent resolving performance, high sensitivity, high solvent resistance and good adhesiveness to solder. It is also suitable for forming a coating film which can serve as a protective mask, such as a solder resist for printed circuit boards.

The present invention is now described further in the following Examples.

EXAMPLE 1

The compounds shown in Table 1 in the parts by weight also shown in the Table 1, and 1 part by weight of benzophenone, 0.4 parts by weight of Michler's ketone and 0.2 parts by weight of phthalocyanine green were dissolved or dispersed in 100 parts by weight of methyl cellosolve to form a photosensitive solution (400 cps (0.4 Pas) viscosity). This is solution was coated on a printed circuit board using a curtain coater and dried to obtain a 70 µm thick coating film. The viscosity was measured by an E type viscometer at a rotor speed of 20 r.p.min. in a state where the photo-sensitive solution was moving to an extent that thixotropy of the solution would not substantially take place. Then the coating film was exposed through an image masking film to a 2 kW ultra-high pressure mercury lamp from a distance of 60 cm, and the degree of adhesion of the masking film was evaluated.

The coating film was then subjected to spray development with a 1,1,1-trichloroethane developing-solution for 2 minutes to obtain a resist image. After evaluating the developability and sensitivity, the film was exposed using a high-pressure mercury lamp at 80 W cm light intensity from a distance of 20 cm at a conveyor speed of 1 m min and then subjected to heat treatment at 135°C for 20 minutes to prepare a sample for evaluation. The results are shown in Table 1.

The evaluation methods and measurements are explained below.

Tackiness of the coating film:

1 ..... No tackiness. Positioning of the masking film could be done without a hitch, and there was no adhesion of the film after exposure.

2 ..... Slight tackiness was observed, but it posed no problem practically.

3-4 ... The coating film had tackiness. It caused some difficulties in positioning the masking film. There was observed adhesion of the masking film after exposure.

5 ..... The coating film had a fairly high degree of tackiness. It was hard to peel off the masking film after exposure.

Developability:

This was evaluated by visually observing the remnant of the resist at the non-exposed portion after development.

1 ..... No resist remained.

≀

3 ..... Resist remained slightly. (Unacceptable for practical use.)

≀

5 ..... It was impossible to carry out development.

Sensitivity:

The number of solid steps was recorded by using Kodak 21-Step Wedge.

Solvent resistance:

Each sample was immersed in dichloromethane at room temperature for one hour, and the separation of the resist and the resist surface roughness were visually observed.

Adhesiveness:

The resist provided on a solder through-holed base plate was immersed in solder at 265°C for 5 seconds. The resist on the solder circuit was then cut into 100 equal portions and subjected to a cellophane tape peel-test, observing whether the resist peeled off or not.

EXAMPLE 2 - 9 and COMPARATIVE EXAMPLES 1 - 8

The samples for evaluation were prepared in the same way as Example 1 except that the compounds shown in Tables 1 and 2 were used in the amounts (parts by weight) specified in Tables 1 and 2. They were evaluated as in Example 1. The results are shown in Tables 1 and 2.

Table 1

| No. | High-molecular compound (A) (part by weight) | Polymerizable monomer (B) (part by weight) | Compound (C) (part by weight) | Extender pigment (part by weight) | Tackiness of coating film | Developability | Sensitivity (number of steps) | Solvent resistance | Adhesiveness |
|---|---|---|---|---|---|---|---|---|---|
| Example 1 | (A) - 1 25 | (B) - 1 25 | (C) - 1 10 | Talc 20 | 2 | 1 | 6 | No problem | 100/100 |
| 2 | (A) - 2 25 | Ditto | Ditto | Ditto | 2 | 1 | 7 | " | 100/100 |
| 3 | (A) - 3 45 | (B) - 1 10 | (C) - 1 5 | Ditto | 2 | 1 | 7 | " | 100/100 |
| 4 | (A) - 1 25 | (B) - 2 25 | (C) - 1 10 | Ditto | 2 | 1 | 6 | " | 100/100 |
| 5 | Ditto | (B) - 1 25 | (C) - 2 10 | Ditto | 2 | 1 | 6 | " | 100/100 |
| 6 | Ditto | Ditto | (C) - 3 10 | Ditto | 1 | 1 | 5 | " | 100/100 |
| 7 | Ditto | Ditto | (C) - 4 10 | Ditto | 1 | 1 | 5 | " | 100/100 |
| 8 | Ditto | (B) - 1 29 | (C) - 4 20 | Talc 6 | 1 | 1 | 5 | " | 100/100 |
| 9 | Ditto | (B) - 1 25 | (C) - 5 10 | Talc 20 | 1 | 1 | 5 | " | 100/100 |

Table 2

| No. | Composition (part by weight) | | | Extender pigment | Tackiness of coating film | Developability | Sensitivity (number of steps) | Solvent resistance | Adhesiveness |
|---|---|---|---|---|---|---|---|---|---|
| Comp. Example 1 | (D) - 1<br>25 | (B) - 1<br>25 | (C) - 1<br>10 | Talc<br>20 | 2 | 1 | 4 | Surface was roughened | 80/100 |
| 2 | (D) - 2<br>25 | Ditto | Ditto | Ditto | 5 | 1 | 6 | No problem | 100/100 |
| 3 | (D) - 3<br>25 | Ditto | Ditto | Ditto | 4 | 3 | 6 | " | 80/100 |
| 4 | (D) - 3<br>40 | (B) - 1<br>10 | Ditto | Ditto | 2 | 5 | 5 | " | 70/100 |
| 5 | (D) - 4<br>25 | (B) - 1<br>25 | Ditto | Ditto | 5 | 3 | 6 | " | 100/100 |
| 6 | (A) - 1<br>25 | (E) - 1<br>35 | | Ditto | 5 | 1 | 6 | Fine line portion peeled | 100/100 |
| 7 | (A) - 1<br>40 | (E) - 1<br>20 | | Ditto | 2 | 1 | 4 | Whole surface peeled | 100/100 |
| 8 | (A) - 1<br>25 | (C) - 3<br>35 | | Ditto | 3 | 1 | 4 | Whole surface peeled | 100/100 |

The compounds shown by symbols in the tables are as follows:

(A)-1

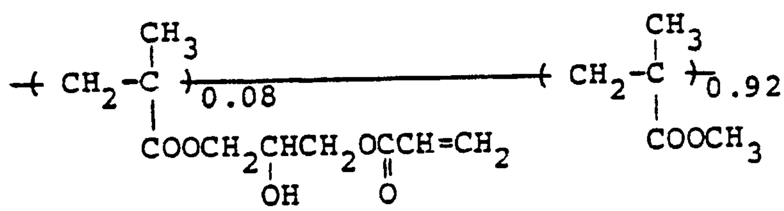

Weight-average molecular weight (hereinafter referred to as Mw) = $17 \times 10^4$

(A)-2

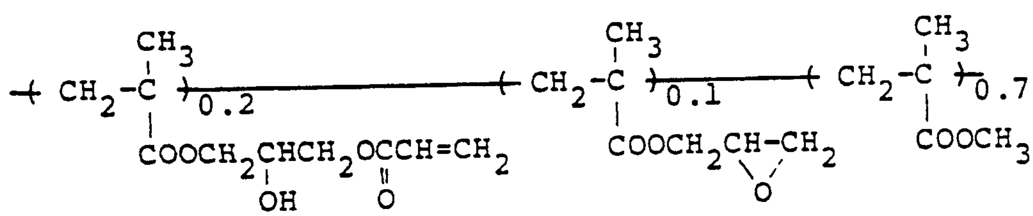

Mw = $10 \times 10^4$

(A)-3

Diallyl phthalate polymer "Daiso Isodap" (made by Osaka Soda Co., Ltd.) Mw = $5 \times 10^4$

(B)-1

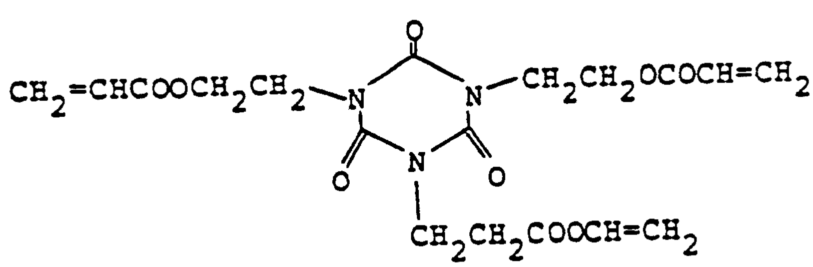

(B)-2

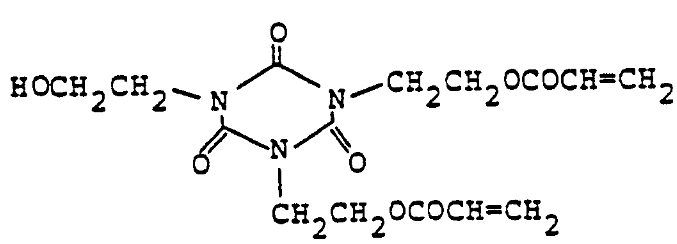

(C)-1

N-vinyl-2-pyrrolidone

(C)-2

$$CH_2=CHCOO \leftarrow CH_2CH_2O \rightarrow_{14} COCH=CH_2$$

(C)-3

A-IP-B-IP-A

(wherein A is 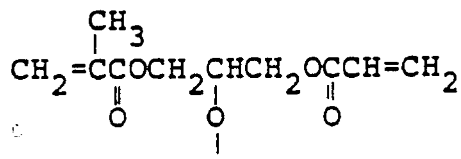 ,

IP is 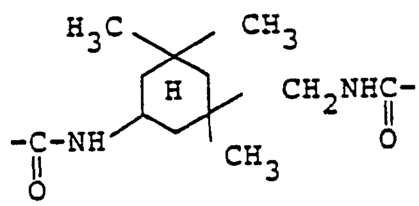 , and

B is 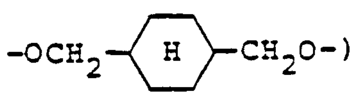

(C)-4

U-108A (urethane acrylate produced by Shin Nakamura Kagaku K.K.)

(C)-5

A-IP-A
(wherein A and IP represent the same as defined above)

(D)-1

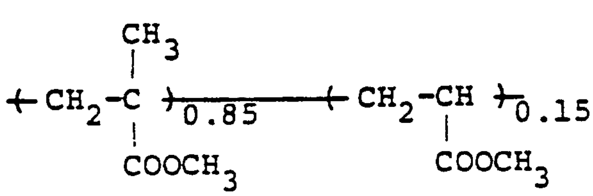

Mw = 10 × $10^4$

(D)-2

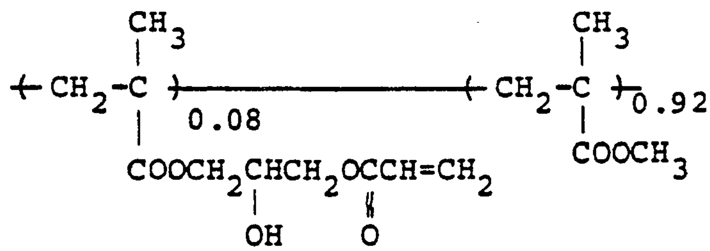

Mw = 5 x $10^3$

(D)-3

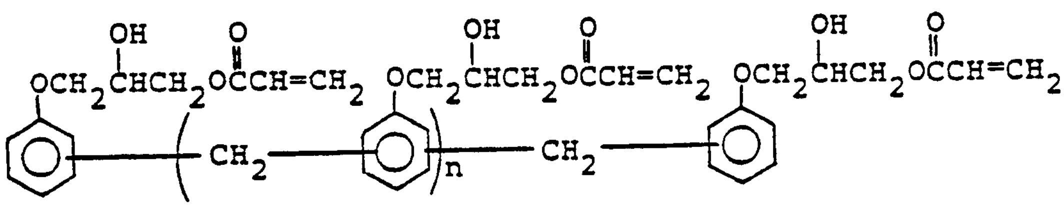

Mw = 3.5 x $10^3$

(D)-4

SP-1507 (bisphenol A type epoxy acrylate produced by Showa Kobunshi K.K.)

(E)-1

Trimethylolpropane triacrylate

## Claims

1. A photopolymerizable composition comprising at least (A) a high-molecular weight compound having a weight-average molecular weight of not less than 10,000 and having a polymerizable double bond in a side chain, and (B) a polymeriable monomer of formula (I):

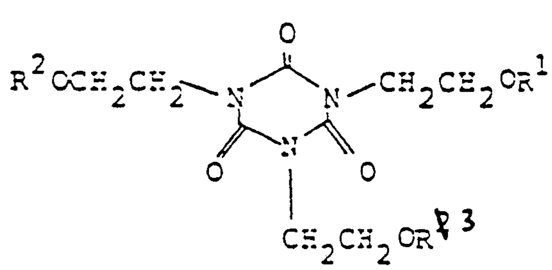

(I)

wnerein $R^1$, $R^2$ and $R^3$ independently are hydrogen or

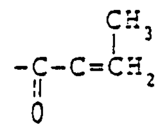

a or

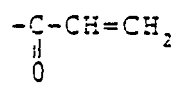

group, with the proviso that two or more of them are not simultaneously hydrogen.

2. A composition according to claim 1 wherein the high-molecular weight compound is present in an amount of from 10 to 80% by weight, and the polymerizable monomer of formula (I) is present in an amount of from 10 to 70% by weight, based on the total solids content of the composition.

3. A composition according to claim 1 or 2 which further comprises at least one substance (C) which is N-vinyl-2-pyrrolidone, a urethane (meth)acrylate compound or a monomer comprising units of formula (II), (D) a photopolymerization initiator or (E) coating solvent: wherein n

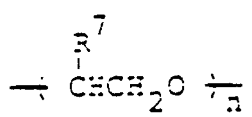

(II)

is from 5 to 25 and $R^7$ is hydrogen or a methyl group.

4. A composition according to claim 3 wherein the at least one substance (C) is present in an amount of not more than 40% by weight based on the total solids content of the composition.

5. A composition according to any one of claims 1 to 4 wherein the high-molecular weight compound comprises units of formula (III):

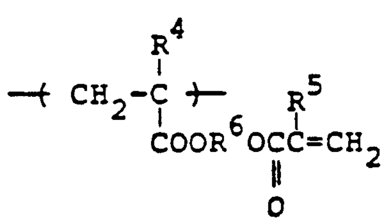

(III)

wherein $R^4$ and $R^5$ independently are hydrogen or a methyl group and $R^6$ is a

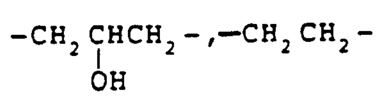

or

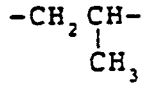

group.

6. A composition according to any one of claims 1 to 5 wherein the weight-average molecular weight of the high-molecular weight compound is from 30,000 to 300,000.

7. A composition according to any one of claims 1 to 6 which further comprises inorganic fine particles having an average diameter of not more than 10 μm.

8. A composition according to claim 7 wherein the inorganic fine particles are present in an amount of from 10 to 50% by weight based on the total solids content of the composition.

9. A composition according to any one of claims 1 to 8 having a viscosity in the range of 0.1 to 1.5 Pas (100 to 1,500 cps) and in a form such that it can be coated on printed circuit boards by a curtain coater.

10. Use of a composition as defined in any one of claims 1 to 9 as a solder photoresist in the production of printed circuit boards.

11. A printed circuit board, electronic part, conductor, resist or printing plate comprising a protective layer of a composition as defined in any one of claims 1 to 9 which has been subjected to a polymerization treatment.

**Revendications**

1. Composition photopolymérisable comprenant au moins (A) un composé de haut poids moléculaire ayant un poids moléculaire moyen en poids non inférieur à 10 000 et comportant une double liaison polymérisable dans une chaîne latérale, et (B) un monomère Polymérisable de formule (I) :

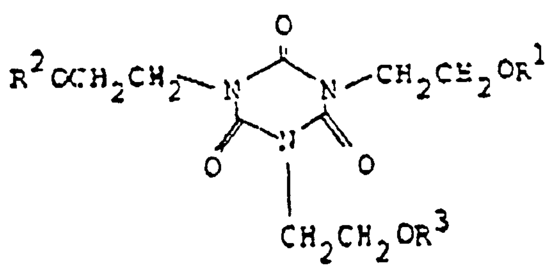

(I)

où $R^1$, $R^2$ et $R^3$ sont indépendamment de l'hydrogène ou un groupe

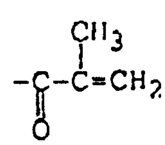

ou

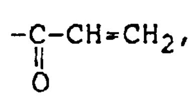

à condition que deux ou plusieurs d'entre eux ne soient pas simultanément de l'hydrogène.

2. Composition selon la revendication 1, dans laquelle le composé de haut poids moléculaire est présent en une quantité de 10 à 80 % en poids, et le monomère polymérisable de formule (I) est présent en une quantité de 10 à 70 % en poids, par rapport au poids de matières sèches totales de la composition.

3. Composition selon la revendication 1 ou 2, qui comprend, de plus, au moins une substance (C) qui est

la N-vinyl-2-pyrrolidone, un uréthanne-(méth)acrylate ou un monomère comprenant des motifs de formule (II), (D) un initiateur de photopolymérisation ou (E) un solvant d'application :

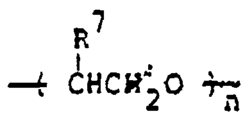

(II)

où n est de 5 à 25 et $R^7$ est l'hydrogène ou un groupe méthyle.

4. Composition selon la revendication 3, dans laquelle la substance (C) est présente en une quantité non supérieure à 40 % en poids, par rapport au poids de matières sèches totales de la composition.

5. Composition selon l'une quelconque des revendications 1 à 4, dans laquelle le composé de haut poids moléculaire comprend des motifs de formule (III) :

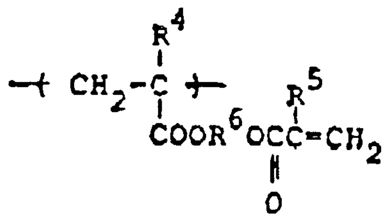

(III)

où $R^4$ et $R^5$ sont indépendamment de l'hydrogène ou un groupe méthyle et $R^6$ est un groupe

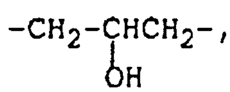

$-CH_2CH_2-$ou

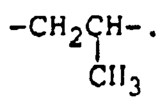

6. Composition selon l'une quelconque des revendications 1 à 5, dans laquelle le poids moléculaire moyen en poids du composé de haut poids moléculaire est de 30 000 à 300 000.

7. Composition selon l'une quelconque des revendications 1 à 6, qui comprend, de plus, de fines particules minérales ayant un diamètre moyen non supérieur à 10 µm.

8. Composition selon la revendication 7, dans laquelle les fines particules minérales sont présentes en une quantité de 10 à 50 % en poids, par rapport au poids de matières sèches totales de la composition.

9. Composition selon l'une quelconque des revendications 1 à 8, dont la viscosité se situe dans l'intervalle de 0,1 à 1,5 Pa.s (100 à 1500 cPo) et qui est sous une forme telle qu'elle peut être appliquée sur des plaquettes de circuits imprimés au moyen d'un appareil d'application au rideau.

10. Utilisation d'une composition telle que définie dans l'une quelconque des revendications 1 à 9 comme résine photosensible pour résist de soudure dans la production de plaquettes de circuits imprimés.

11. Plaquette de circuit imprimé, composant électronique, conducteur, réserve ou cliché d'impression comprenant une couche protectrice d'une composition telle que définie dans l'une quelconque des revendications 1 à 9, qui a été soumise à un traitement de polymérisation.

## Ansprüche

1. Photopolymerisierbare Masse enthaltend mindestens (A) eine hochmolekulare Verbindung mit einem gewichtsmittleren Molekulargewicht von nicht weniger als 10.000 und einer polymerisierbaren Doppelbindung in einer Seitenkette und (B) ein polymerisierbares Monomer der Formel (I)

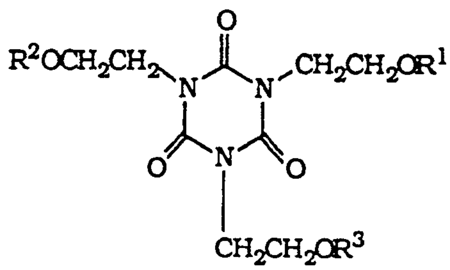

(I)

worin $R^1$, $R^2$ und $R^3$ unabhängig voneinander Wasserstoff oder eine Gruppe der Formel

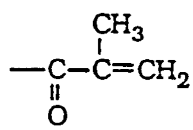

oder eine Gruppe der Formel

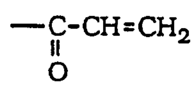

mit der Maßgabe bedeuten, daß nicht gleichzeitig zwei oder mehr Gruppen dieser Art Wasserstoff bedeuten.

2. Masse nach Anspruch 1, worin die hochmolekulare Verbindung in einer Menge von 10 bis 80 Gew.-% und das polymerisierbare Monomer der Formel (I) in einer Menge von 10 bis 70 Gew.-%, bezogen auf den gesamten Feststoffgehalt der Masse vorhanden sind.

3. Masse nach Anspruch 1 oder 2, enthaltend zusätzlich mindestens eine Substanz (C), welche N-Vinyl-2-pyrrolidon, eine Urethan-(meth)acrylat-Verbindung oder ein Monomer, welches Einheiten der Formel (II) enthält:

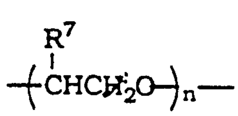

(II)

in der n 5 bis 25 und $R^7$ Wasserstoff oder eine Methylgruppe bedeuten (D) einen Photopolymerisationsinitiator oder(E) ein Beschichtungslösungsmittel.

4. Masse nach Anspruch 3, worin die mindestens eine Substanz (C) in einer Menge von nicht mehr als 40 Gew.-% bezogen auf den Gesamtfeststoffgehalt der Masse. vorhanden ist.

5. Masse nach einem der Ansprüche 1 bis 4, worin die hochmolekulare Verbindung Einheiten der Formel (III)

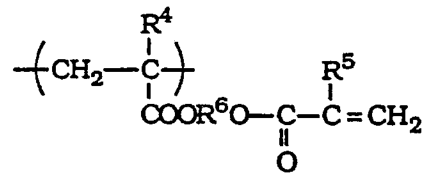

(III)

enthält, in der $R^4$ und $R^5$ unabhängig voneinander Wasserstoff oder Methylgruppen und $R^6$ eine Gruppe der Formeln

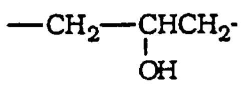 , $-CH_2-CH_2-$ oder 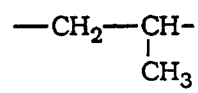

bedeuten.

6. Masse nach einem der Ansprüche 1 bis 5, worin das gewichtsmittlere Molekulargewicht der hochmolekularen Verbindung 30.000 bis 300.000 beträgt.

7. Masse nach einem der Ansprüche 1 bis 6 enthaltend zusätzlich feinteilige anorganische Teilchen mit einem durchschnittlichen Durchmesser von nicht mehr als 10 µm.

8. Masse nach Anspruch 7, worin die feinteiligen anorganischen Teilchen in einer Menge von 10 bis 50 Gew.-%, bezogen auf den Gesamtfeststoffgehalt der Masse vorhanden sind.

9. Masse nach einem der Ansprüche 1 bis 8 mit einer Viskosität im Bereich von 0,1 bis 1,5 Pas(100 bis 1.500cPs) und in einer solchen Form, daß sie mit Hilfe einer Gießvorrichtung auf gedruckte Schaltkreisplatten aufgebracht werden kann.

10. Verwendung einer Masse nach einem der Ansprüche 1 bis 9 Löt-Photoresist bei der Herstellung von gedruckten Schaltkreisplatten.

11. Gedruckte Schaltkreisplatte, elektronisches Bauteil, Leiter, Widerstand oder Druckplatte, enthaltend eine Schutzschicht aus einer Masse nach einem der Ansprüche 1 bis 9, welcher einer Polymerisationsbehandlung unterworfen worden ist.